Europäisches Patentamt

**European Patent Office**

Office européen des brevets

(11) Veröffentlichungsnummer: **0 057 753**
**B1**

(12) **EUROPÄISCHE PATENTSCHRIFT**

(45) Veröffentlichungstag der Patentschrift:
**25.09.85**

(51) Int. Cl.⁴: **H 04 B 14/04**

(21) Anmeldenummer: **81108726.1**

(22) Anmeldetag: **22.10.81**

(54) Verfahren zur Umwandlung linear codierter PCM-Worte in nichtlinear codierte PCM-Worte und umgekehrt nichtlinear codierter PCM-Worte in linear codierte PCM-Worte gemäss einer dem A-Gesetz gehorchenden 13-Segment-Kennlinie.

(30) Priorität: **09.02.81 DE 3104513**

(43) Veröffentlichungstag der Anmeldung:
**18.08.82 Patentblatt 82/33**

(45) Bekanntmachung des Hinweises auf die Patenterteilung:
**25.09.85 Patentblatt 85/39**

(84) Benannte Vertragsstaaten:
**AT CH FR GB IT LI NL SE**

(56) Entgegenhaltungen:
**DE - A - 2 131 635**
**DE - B - 1 803 222**
**US - A - 3 789 392**

**BELL SYSTEM TECHNICAL JOURNAL, Band 49, Nr. 7, September 1970 NEW YORK (US) KANEKO: "A Unified Formulation of Segment Companding Laws and Synthesis of Codecs and Digital Compandors", Seiten 1555-1588**

(73) Patentinhaber: **Siemens Aktiengesellschaft, Berlin und München Wittelsbacherplatz 2, D-8000 München 2 (DE)**

(72) Erfinder: **Zeiträg, Rolf, Dipl.-Phys., Dompfaffweg 3, D-8000 München 82 (DE)**

## Beschreibung

Die Erfindung betrifft ein Verfahren zur Umwandlung linear codierter PCM-Worte in nichtlinear codierte PCM-Worte (Kompandierung) und umgekehrt nichtlinear codierter PCM-Worte in linear codierte PCM-Worte (Linearisierung) gemäss einer dem A-Gesetz gehorchenden 13-Segment-Kennlinie unter Verwendung eines Schieberegisters, in das im Falle der Kompandierung ein linear codiertes PCM-Wort eingegeben und dort so lange verschoben wird, bis ein signifikantes Bit am Schieberegisterserienausgang erscheint, wonach zur Bildung des nichtlinear codierten PCM-Wortes das Komplement der die Anzahl der hierfür erforderlichen Schiebetakte kennzeichnenden Bitkombination als höherwertiger Wortteil und eine Anzahl von auf das genannte signifikante Bit folgender, im Schieberegister stehender Bit als niedrigerwertiger Wortteil herangezogen werden, und im Falle der Linearisierung der der Stufung innerhalb der Segmente der genannten Kennlinie entsprechende niedrigerwertige Wortteil eines nichtlinear codierten PCM-Wortes eingegeben und dort um eine Anzahl von Stellen verschoben wird, die mit der durch den nicht berücksichtigten Teil des nichtlinear codierten PCM-Wortes bezeichneten betreffenden Segmentnummer der Kennlinie in Zusammenhang steht, worauf er mit der hierdurch veränderten Wertigkeit zur Bildung des höherwertigen Teiles des linear codierten PCM-Wortes herangezogen wird.

Eine derartige Umwandlung von linearer Codedarstellung in nichtlineare Codedarstellung und umgekehrt ist insbesondere im Zusammenhang mit der digitalen Vermittlung von Konferenzgesprächen von Interesse, da in deren Verlauf aus den von den einzelnen Konferenzteilnehmern gelieferten PCM-Worten, die im Interesse eines konstanten Signal-Rausch-Verhältnisses eine nichtlineare Codedarstellung aufweisen, Summencodeworte gebildet werden müssen. Eine derartige Summenbildung ergibt aber nur dann zutreffende Ergebnisse, wenn die einzelnen zu addierenden PCM-Worte vorher einer Linearisierung unterworfen sind. Vor einer Weiterübertragung des Summencodewortes hat dann wieder eine Umwandlung in nichtlineare Codedarstellung stattzufinden.

Die vorerwähnte den Umwandlungen zugrunde gelegte, dem A-Gesetz gehorchende 13-Segment-Kennlinie zeichnet sich durch einen regelmässigen Verlauf aus, aufgrund dessen die Codewandlungen in der vorstehend angegebenen Art und Weise durch entsprechende Verschiebe- und Zählvorgänge durchgeführt werden können. Ausgenommen von dieser Regelmässigkeit ist allerdings das erste Segment jeder Kennlinienhälfte, weswegen bei einem bekannten Verfahren, (DE-A-1 803 222), das in der obenstehend beschriebenen Art und Weise arbeitet, soweit PCM-Worte betroffen sind, die auf diesem ersten Segment liegen, abweichend von der Behandlung von PCM-Worten übriger Segmente bei einer Umwandlung von nichtlinear codierten PCM-Worten in linear codierte PCM-Worte an die Bits der nichtlinear codierten PCM-Worte weitere Bitkombinationen angesetzt werden bzw. bei einer Umwandlung in umgekehrter Richtung einzelne Bits eines umzuwandelnden linear codierten PCM-Wortes unterdrückt werden.

Aufgabe der Erfindung ist es daher, das eingangs genannte Verfahren so auszugestalten, dass unabhängig davon, welchem Segment die umzuwandelnden PCM-Worte angehören, bei den entsprechenden Umwandlungen grundsätzlich in gleicher Weise verfahren werden kann.

Erfindungsgemäss wird diese Aufgabe dadurch gelöst, dass bei einer Kompandierung ein Weiterschieben des in das Schieberegister eingegebenen, umzuwandelnden linear codierten PCM-Wortes auch dann verhindert wird, wenn das genannte signifikante Bit nicht am Schieberegisterserienausgang erscheint, aber Informationsschiebungen in einer Anzahl stattgefunden haben, die um 1 kleiner ist als die höchste Segmentnummer, und ein zum Abzählen der Schiebetakte dienender Zähler, der normalerweise bei Erscheinen des signifikanten Bits angehalten wird und dessen Zählerstand dann das Komplement der Nummer des Segmentes angibt, auf dem das umgewandelte PCM-Wort liegt, in seinen Zählerendstand weitergeschaltet wird, und dass bei einer Linearisierung der der Stufung innerhalb eines Segmentes entsprechende niedrigwertige Teil eines nichtlinear codierten PCM-Wortes vor einer Eingabe in das Schieberegister, sofern das PCM-Wort dem niedrigstwertigen Segment der Kennlinie zugeordnet ist, zu einer bestimmten Bitkombination und, sofern es einem höherwertigen Segment zugeordnet ist, zu einer anderen bestimmten Bitkombination addiert wird.

Aufgrund des erfindungsgemässen Vorgehens erfolgt eine grundsätzliche Gleichbehandlung aller PCM-Worte bei den Umwandlungen in der einen oder in der anderen Richtung. Abgesehen von einem einheitlichen Steuerungskonzept ergibt sich hierdurch der besondere Vorteil, dass ein solches Verfahren mit einem vorgeschlagenen Verfahren kompatibel ist, demgemäss solche Codewandlungen entsprechend einer Kennlinie durchgeführt werden, die dem μ-Gesetz gehorcht. Bei diesem μ-Gesetz erstreckt sich nämlich die beim A-Gesetz nur bezüglich des ersten Segmentes vorhandene Unregelmässigkeit über sämtliche Segmente, weswegen dort, um überhaupt Codewandlungen in Form von Verschiebe- und Zählvorgängen vornehmen zu können, Massnahmen ergriffen werden, die hier lediglich im Hinblick auf das erste Segment erforderlich werden. Es lässt sich daher dann eine Schaltungsanordnung, die zur Durchführung des genannten Verfahrens zugrunde des μ-Gesetzes arbeitet, ohne grossen Aufwand auf eine Arbeitsweise nach dem A-Gesetz umschaltbar machen.

Nachstehend wird das erfindungsgemässe Verfahren anhand eines Ausführungsbeispiels unter Bezugnahme auf zwei Figuren näher erläutert.

Fig. 1 zeigt die Gegenüberstellung einer Codetabelle linear codierter Signalwerte und einer Codetabelle zugeordneter nichtlinear codierter Signalwerte.

Fig. 2 zeigt ein Blockschaltbild einer Schaltungsanordnung zur Durchführung des erfindungsgemässen Verfahrens.

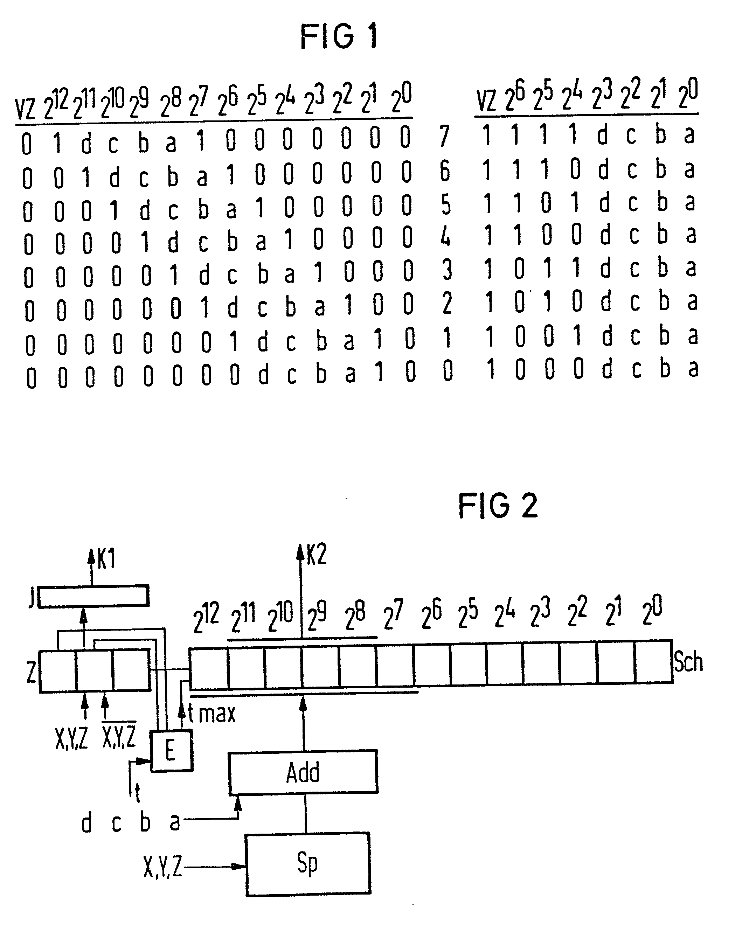

Die im linken Teil der Figur 1 dargestellten Bitkombinationen aus der Bits $2^0$ bis $2^{12}$, zu denen noch ein Vorzeichenbit VZ als höchstwertiges Bit kommt, stellen linear codierte Signalwerte dar. Im rechten Teil der Figur sind Kombinationen aus acht Bits $2^0$ bis VZ dargestellt, die die entsprechenden nichtlinear codierten Signalwerte veranschaulichen. Die zwischen den beiden Codegruppen eingetragenen Zahlen 0 bis 7 geben an, dass die entsprechenden Zeilen die Segmente 0 bis 7 der positiven oder der negativen Kennlinienhälfte betreffen, je nachdem, ob das Bit VZ den Binärwert 1 oder den Binärwert 0 aufweist. Die Segmente 0 und 1 beider Kennlinienhälften weisen jeweils dieselbe Steigung auf, so dass die vollständige Kennlinie tatsächlich, wie oben angegeben, aus dreizehn Geraden zusammengesetzt ist. Wie die nichtlineare Codedarstellung im rechten Teil der Figur zeigt, sind sämtliche der Segmente 0 bis 7 in sechzehn gleich grosse Stufen unterteilt, entsprechend den sechzehn möglichen unterschiedlichen Kombinationen d,c,b,a der vier niedrigerwertigen Bits $2^0$ bis $2^3$. Die drei auf das Vorzeichen-Bit VZ folgenden höherwertigen Bit $2^6$ bis $2^4$ nehmen vom Segment 0 bis zum Segment 7 unterschiedliche Kombinationen 000 und 111 an und stellen die Segmentadresse dar.

Aus dem Vergleich der beiden Codetabellen erkennt man, dass die bei einem nichtlinear codierten PCM-Wort die Stufen innerhalb eines Segments angebende Bitkombination d,c,b,a in dem entsprechenden linearcodierten PCM-Wort ebenfalls auftauchen, je nachdem welchem Segment das nichtlinear codierte PCM-Wort angehört, jedoch mit anderer Stellenwertigkeit, nämlich mit steigender Segmentnummer zu höheren Wertigkeiten hin verschoben sind.

Man erkennt ferner, dass bei den linear codierten PCM-Worten die Bitkombination d,c,b,a jeweils zwischen einem höherwertigen und niedrigerwertigen Bit des Binärwertes 1 steht, mit Ausnahme der dem Segment 0 zugehörenden Bitkombination, die zwischen einem höherwertigen Bit des Binärwertes 0 und einem niedrigerwertigen Bit des Binärwertes 1 steht.

Die in Fig. 2 dargestellte Anordnung zur Durchführung des erfindungsgemässen Verfahrens, die lediglich insoweit gezeigt ist, als dies zum Verständnis der Erfindung erforderlich erscheint, weist als wesentlichen Bestandteil ein Schieberegister SCH auf, das unter der aus Fig. 1 ersichtlichen Voraussetzung, dass linear codierte PCM-Worte unter Verwendung von dreizehn Bit dargestellt werden, aus dreizehn Schieberegisterstufen besteht. Ferner ist Bestandteil dieser Anordnung ein Zähler Z, der unter der Voraussetzung einer aus dreizehn Segmenten bestehenden Kennlinie, wie sie die A-Kennlinie ist, drei Stufen aufweist, also acht verschiedene Zählerzustände einnehmen kann, was ausreicht, da PCM-Worte, die unterschiedlichen Kennlinienhälften zugeordnet sind, jeweils gesondert behandelt werden und je Kennlinienhälfte lediglich acht unterscheidbare Segmente auftreten.

Weiterer Bestandteil der Anordnung gemäss Fig. 2 ist eine Addiereinrichtung Add, der im Zuge einer Linearisierung die Codekombination d,c,b,a nichtlinear codierter PCM-Worte zugeführt wird. Ferner ist Bestandteil der dargestellten Anordnung ein Speicher Sp, in dem bestimmte Bitkombinationen gespeichert sind, die, wie noch erläutert werden wird, den Betriebsverhältnissen entsprechend abgerufen und als jeweils zweite Eingangsgrösse dem Addierer Add zugeführt werden. Die von dem Addierer gebildeten Summencodeworte werden an das genannte Schieberegister SCH übergeben.

Nachstehend werden die Vorgänge näher erläutert, die sich in Durchführung des erfindungsgemässen Verfahrens bei der Umwandlung von PCM-Worten von der einen Codierungsart in die andere abspielen.

Zunächst wird die Umwandlung positiver linear codierter PCM-Worte in nichtlinear codierte PCM-Worte, also eine Kompandierung, behandelt. Hierzu wird das umzuwandelnde linear codierte PCM-Wort in das Schieberegister SCH eingegeben. Der Zähler Z wird auf den Zählerstand 0 gestellt. Nunmehr wird unter dem Einfluss von Taktimpulsen t das im Schieberegister SCH befindliche PCM-Wort so lange nach links verschoben, bis in der Schieberegisterstufe $2^{12}$ ein Bit des Binärwertes 1 erscheint, worauf ein Weiterschieben im Schieberegister und ein Weiterzählen des Zählers Z unterbunden wird. Bei dem erwähnten Bit des Binärwertes 1 handelt es sich um dasjenige des linear codierten PCM-Wortes, das, wie die Fig. 1 zeigt, als höherwertiges Bit an die Bitkombination d,c,b,a angrenzt. Die Einbeziehung der Schieberegisterstufe $2^{12}$ in die Auswertung bedeutet, dass vom jeweils doppelten Linearwert ausgegangen worden ist, was aber deswegen zulässig ist, weil dieser Umstand bei einer nachfolgenden Umwandlung in umgekehrter Richtung Berücksichtigung findet. Das entsprechende nichtlinear codierte PCM-Wort wird nun aus einer Bitkombination, die das Komplement des aktuellen Zählerstandes des Zählers Z darstellt, also die Anzahl der beim linear codierten PCM-Wort vor dem genannten Bit des Binärwertes 1 stehende Anzahl von Bits des Binärwertes 0 angibt, als höherwertiger Teil sowie aus den in den Stufen $2^{11}$ bis $2^8$ des Schieberegisters stehenden Bits als niedrigerwertiger Teil gebildet, was durch die mit K1 und K2 bezeichneten Ausgangspfeile an dem dem Zähler Z nachgeschalteten Inverter I bzw. an den genannten Stufen des Schieberegisters angedeutet ist.

Da, wie erläutert, bei linear codierten PCM-Worten, die dem Segment 0 zugeordnet sind, ein an die Bitkombination d,c,b,a angrenzendes höherwertiges Bit des Binärwerts 1 nicht vorhanden ist, wird die Anzahl der Schiebeschritte des Schieberegisters SCH auf $t_{max} = 6$ begrenzt, beispielsweise durch Verknüpfung des das Weiterschieben bewirkenden Taktes t mit den beim Zählerstand 6 des Zählers Z abgegebenen Ausgangssignalen, wogegen der Zähler Z noch durch einen nachfolgenden Zähltakt weitergeschaltet werden kann, und damit den Zählerstand 7 erreicht. Auch hier wird das nichtlinear codierte PCM-Wort wieder aus dem Komplement des dann erreichten Zählerstandes und den Bits in den Stufen $2^{11}$ bis $2^8$ des Schieberegisters SCH gebildet.

Bei einer Umwandlung in umgekehrter Richtung, also bei einer Linearisierung, wird der der Stufung innerhalb eines Segmentes entsprechende niedrigerwertige Teil d,c,b,a eines nichtlinear codierten PCM-Wortes jeweils vor einer Eingabe in das Schieberegister SCH zu einer bestimmten Bitkombination addiert, die davon abhängt, ob das umzucodierende PCM-Wort dem niedrigstwertigen Segment oder einem der höherwertigen Segmente zugeordnet ist. Die Bits der hinzuzuaddierenden Bitkombination haben jeweils einen derartigen Binärwert, dass bei PCM-Worten mit positivem Vorzeichen, die dem niedrigstwertigen Segment zugeordnet sind, die Summe 0dcba1 entsteht und bei PCM-Worten mit positivem Vorzeichen, die einem der übrigen Segmente zugeordnet sind, die Summe 1dcba1 entsteht.

Die genannten beiden hinzuzuaddierenden Bitkombinationen werden aufgrund entsprechender Ansteuerung mit den die Segmentadresse des umzuwandelnden PCM-Wortes angebenden höherwertigen Bits x,y,z dem Speicher Sp der Anordnung gemäss Fig. 2 entnommen und dem Addierer Add zugeführt, an dessen anderem Eingang die die Segmentstufung angebenden Bits d,c,b,a des umzuwandelnden PCM-Wortes anliegen. Das durch den Addierer gebildete Summencodewort wird dann in die Stufen $2^{12}$ bis $2^9$ des Schieberegisters SCH eingegeben und dort um eine Anzahl von Stufen nach rechts verschoben, die sich aus dem Komplement der Segmentnummer des umzuwandelnden PCM-Wortes ergibt, sofern es sich um den Segmenten 1 bis 7 zugeordnete PCM-Worte handelt. Ist das umzuwandelnde PCM-Wort dem Segment 0 zugeordnet, dann ist dafür Sorge zu tragen, dass in Abweichung von der oben erwähnten Zuordnung von Schiebetakten zu Segmentnummer genau so viele Verschiebungen vorgenommen werden, wie bei einem PCM-Wort, das dem Segment 1 zugeordnet ist. Man könnte allerdings auch so vorgehen, dass bei der Summenbildung nicht wie angegeben die Summe 0dcba1 erzeugt wird, sondern die Summe dcba1, die dann ebenfalls in die Stufen $2^{11}$ und die nachfolgenden niedrigerwertigen Stufen des Schieberegisters eingegeben wird, in welchem Falle dann ein Schiebtakt mehr wirksam werden muss, als bei einem PCM-Wort, das dem Segment 1 zugeordnet ist.

Unter der Voraussetzung, dass die bei der beschriebenen Schiebeaktion freiwerdenden Stufen des Schieberegisters SCH dem Binärwert 0 entsprechend eingestellt werden, stellt dann der nach Abschluss der Schiebeoperation erhaltene Belegungszustand der Stufen $2^{12}$ bis $2^0$ des Schieberegisters SCH den zweifachen Wert des linear codierten PCM-Wortes dar.

Insbesondere bei dieser Art der Umwandlung, also bei der Linearisierung, zeigt sich die Kompatibilität zu dem erwähnten vorgeschlagenen Verfahren zur Codeumwandlung nach dem μ-Gesetz, das bei der Linearisierung das Hinzuaddieren von Segment zu Segment unterschiedlicher Bitkombination zu den die Stufung angebenden Bits dcba eines nichtlinear codierten PCM-Wortes erfordert.

Bei PCM-Worten mit negativem Vorzeichen, das sich von PCM-Worten mit positivem Vorzeichen durch den anderen Binärwert des höchstwertigen Bits VZ unterscheidet, spielen sich dieselben Vorgänge ab.

Gerade im Zusammenhang mit der Bildung von Summencodeworten im Zuge der Vermittlung von Konferenzgesprächen, für die das erfindungsgemässe Verfahren vorzugsweise Verwendung finden kann, ist es zweckmässig, PCM-Worte mit negativem Vorzeichen in Form des Zweierkomplexes der entsprechenden PCM-Worte mit positivem Vorzeichen darzustellen. Es lassen sich dann nämlich Subtraktionen von PCM-Worten auf Additionen des entsprechenden Zweierkomplementes zurückführen, was zu einer Vereinfachung bei der Bildung der Konferenzsummenworte führt.

Bei der Kompandierung unterscheidet sich das Vorgehen von dem für positive PCM-Worte gültigen dadurch, dass bei Weiterschieben des betreffenden in das Schieberegister SCH eingetragenen Zweierkomplementes der Serienausgang des Schieberegisters nicht auf das Auftreten eines Bits des Binärwerts 1 sondern auf das Auftreten eines Bits des Binärwertes 0 überwacht wird.

Bei der Linearisierung wird so vorgegangen, dass nicht zu dem Wortteil d,c,b,a des umzuwandelnden PCM-Wortes, sondern zu dessen invertierten Wert eine bestimmte Bitkombination vor der Eingabe in das Schieberegister SCH addiert wird und zwar derart, dass sich bei PCM-Worten, die den Segmenten 1 bis 7 zugeordnet sind, der Summenwert $0,\bar{d},\bar{c},\bar{b},\bar{a},1$ und bei den PCM-Worten, die dem Segment 0 zugeordnet sind, der Summenwert $1,\bar{d},\bar{c},\bar{b},\bar{a},1$ ergibt.

**Patentanspruch**

1. Verfahren zur Umwandlung linear codierter PCM-Worte in nichtlinear codierte PCM-Worte (Kompandierung) und umgekehrt nichtlinear codierter PCM-Worte in linear codierte PCM-Worte (Linearisierung) gemäss einer dem A-Gesetz gehorchenden 13-Segment-Kennlinie unter Verwendung eines Schieberegisters, in das im Falle der Kompandierung ein linear codiertes PCM-Wort eingegeben und dort so lange verschoben wird, bis ein signifikantes Bit am Schieberegisterserienausgang erscheint, wonach zur Bildung des nichtlinear codierten PCM-Wortes das Komplement der die Anzahl der hierfür erforderlichen Schiebetakte kennzeichnende Bitkombination als höherwertiger Wortteil und eine Anzahl von auf das genannte signifikante Bit folgender, im Schieberegister stehender Bits als niedrigerwertiger Wortteil herangezogen werden, und im Fall der Linearisierung der der Stufung innerhalb der Segmente der genannten Kennlinie entsprechende niedrigerwertige Wortteil eines nichtlinear codierten PCM-Wortes eingegeben und dort um eine Anzahl von Stellen verschoben wird, die mit der durch den nicht berücksichtigten Teil des nichtlinear codierten PCM-Wortes bezeichneten betreffenden Segmentnummer der Kennlinie in Zusammenhang steht, woraufhin er mit der hierdurch veränderten Wertigkeit zur Bildung des höherwertigen Teiles des linear codierten PCM-Wortes herangezogen wird, dadurch gekennzeichnet, dass bei einer Kompandierung ein Weiterschieben des in das Schieberegister (SCH) eingegebenen, umzuwandelnden linear codierten PCM-Wortes (L) auch dann verhindert wird, wenn das genannte signifikante Bit nicht am Schieberegisterserienausgang erscheint, aber Informationsschiebungen in einer Anzahl stattgefunden haben, die um 1 kleiner ist als die höchste Segmentnummer (7), und ein zum Abzählen der Schiebetakte (t dienender Zähler (Z), der normalerweise bei Erscheinen des signifikanten Bits angehalten wird und dessen Zählerstand dann das Komplement der Nummer des Segmentes angibt, auf dem das umgewandelte PCM-Wort liegt, in seinen Zählerendstand weitergeschaltet wird, und dass bei einer Linearisierung der der Stufung innerhalb eines Segmentes entsprechende niedrigerwertige Teil (d,c,b,a) eines nichtlinear codierten PCM-Wortes (K) vor einer Eingabe in das Schieberegister (SCH), sofern das PCM-Wort dem niedrigstwertigen Segment (0) der Kennlinie zugeordnet ist, zu einer bestimmten Bitkombination und, sofern es einem höherwertigen Segment zugeordnet ist, zu einer anderen bestimmten Bitkombination addiert wird.

**Claim**

1. Method of converting linear-coded PCM-words into non-linear-coded PCM-words (companding) and *vice versa* for converting non-linear-coded PCM-words (linearisation), in accordance with a 13-segment curve which obeys the A-law, using a shift register into which, in the case of companding, a linear-coded PCM-word is input and is shifted until a significant bit appears at the shift register series output, whereupon, for the formation of the non-linear-coded PCM-word, the complement of the bit combination which characterises the number of shift clock pulses required for this purpose is used as higher-value word component, and a number of bits which follow the aforementioned significant bit and which are contained in the shift register are used as lower value word component, and in the case of linearisation, the lower-value word component of a non-linear-coded PCM-word, which word component corresponds to the grading within the segments of the aforementioned curve, is input and shifted by a number of digits which is related to the relevant segment number of the curve, designated by that part of the non-linear-coded PCM-word which has not been taken into account, whereupon it is used, with the value which has been hereby changed, in order to form the higher-value part of the linear-coded PCM-word, characterised in that in the case of companding, the advance of the linear-coded PCM-word (L) which has been input into the shift register (SCH) and which is to be converted is prevented also when the aforementioned significant bit does not appear at the shift register series output but information shifts have taken place in a number which is 1 smaller than the highest segment number (7), and a counter (Z) which serves to count the shift clock pulses (t) and which is normally brought to a halt when the significant bit appears and whose count then indicates the complement of the number of the segment at which the converted PCM-word is located, is stepped on to its end count, and that in the case of linearisation, the lower-value portion (d,c,b,a) of a non-linear-coded PCM-word (K) which portion corresponds to the grading within a segment, prior to input into the shift register (SCH), is added to a specific bit combination if the PCM-word is assigned to the lowest-value segment (0) of the curve, and is added to another specific bit combination if it is assigned to a higher-value bit combination.

**Revendication**

1. Procédé pour convertir des mots MIC codés linéairement en des mots MIC codés non linéairement (compression) et inversement pour convertir des mots MIC codés non linéairement en mots MIC codés linéairement (linéarisation) conformément à une courbe caractéristique à 13 segments obéissant à la loi A, moyennant l'utilisation d'un registre à décalage dans lequel un mot MIC codé linéairement est introduit dans le cas de la compression et y est décalé jusqu'à ce qu'un bit significatif apparaisse à la sortie série du registre à décalage, à la suite de quoi pour former le mot MIC codé non linéairement, ou utilise le complément de la combinaison binaire, qui caractérise le nombre des impulsions de décalage nécessaires à cet effet, en tant que partie de mot de poids supérieur et un nombre de bits succédant au bit significatif indiqué et présent dans le registre à décalage, en tant que partie de mot de poids inférieur, et dans lequel, dans le cas de la linéarisation, la partie de mot de poids inférieur, qui correspond à l'étagement à l'intérieur des segments de ladite courbe caractéristique, d'un mot MIC codé non linéairement est introduite est décalée d'un certain nombre de places, qui est associé au numéro du segment de la courbe caractéristique, qui est désigné par la partie non prise en compte du mot MIC codé non linéairement, à la suite de quoi ladite partie de mot est utilisée avec le poids ainsi modifié pour former la partie de poids supérieur du mot MIC codé linéairement, caractérisé par le fait que lors d'une compression, la poursuite du décalage du mot MIC (L) codé linéairement, devant être converti et introduit dans le registre à décalage (SCH), est également empêchée lorsque ledit bit significatif n'apparaît pas à la sortie série du registre à décalage, mais que des décalages d'information se sont produits en un nombre qui est supérieur d'une unité au nombre maximum (7) de segments, et que l'état de comptage d'un compteur (Z) qui compte les impulsions de cadence (t) et qui est arrêté normalement lors de l'apparition du bit significatif et dont l'état de comptage indique le complément du numéro du segment dans lequel le mot MIC converti se trouve, est avancé et que, dans le cas d'une linéarisation, la partie (d, c, b, a) de poids inférieur, correspondant à l'étagement intérieur d'un segment, d'un mot MIC (K) codé non linéairement est ajoutée à une combinaison déterminée de bits, avant son introduction dans le registre à décalage (SCH), dans la mesure où le mot MIC est associé au segment de poids le plus faible (0) de la courbe caractéristique, et à une autre combinaison déterminée de bits, dans la mesure où ce mot est associé à un segment de poids supérieur.

# FIG 1

| VZ | $2^{12}$ | $2^{11}$ | $2^{10}$ | $2^9$ | $2^8$ | $2^7$ | $2^6$ | $2^5$ | $2^4$ | $2^3$ | $2^2$ | $2^1$ | $2^0$ | | VZ | $2^6$ | $2^5$ | $2^4$ | $2^3$ | $2^2$ | $2^1$ | $2^0$ |
|---|---|---|---|---|---|---|---|---|---|---|---|---|---|---|---|---|---|---|---|---|---|---|
| 0 | 1 | d | c | b | a | 1 | 0 | 0 | 0 | 0 | 0 | 0 | 0 | 7 | 1 | 1 | 1 | 1 | d | c | b | a |
| 0 | 0 | 1 | d | c | b | a | 1 | 0 | 0 | 0 | 0 | 0 | 0 | 6 | 1 | 1 | 1 | 0 | d | c | b | a |
| 0 | 0 | 0 | 1 | d | c | b | a | 1 | 0 | 0 | 0 | 0 | 0 | 5 | 1 | 1 | 0 | 1 | d | c | b | a |
| 0 | 0 | 0 | 0 | 1 | d | c | b | a | 1 | 0 | 0 | 0 | 0 | 4 | 1 | 1 | 0 | 0 | d | c | b | a |
| 0 | 0 | 0 | 0 | 0 | 1 | d | c | b | a | 1 | 0 | 0 | 0 | 3 | 1 | 0 | 1 | 1 | d | c | b | a |
| 0 | 0 | 0 | 0 | 0 | 0 | 1 | d | c | b | a | 1 | 0 | 0 | 2 | 1 | 0 | 1 | 0 | d | c | b | a |
| 0 | 0 | 0 | 0 | 0 | 0 | 0 | 1 | d | c | b | a | 1 | 0 | 1 | 1 | 0 | 0 | 1 | d | c | b | a |
| 0 | 0 | 0 | 0 | 0 | 0 | 0 | 0 | d | c | b | a | 1 | 0 | 0 | 1 | 0 | 0 | 0 | d | c | b | a |

# FIG 2